# EUROPÄISCHE PATENTSCHRIFT

(11) **EP 2 051 279 B1**
(45) Veröffentlichungstag und Bekanntmachung des Hinweises auf die Patenterteilung: **10.11.2010**
(21) Anmeldenummer: 08017596.1
(22) Anmeldetag: 08.10.2008
(51) Int. Cl.: H01J 37/153, H01J 37/28, H01J 37/145

(54) **Korrektor**
Corrector
Correcteur

(30) Priorität: 20.10.2007 DE 102007049816
(43) Veröffentlichungstag der Anmeldung: 22.04.2009
(73) Patentinhaber: Ceos Corrected Electron Optical Systems GmbH, 69126 Heidelberg (DE)
(72) Erfinder: Zach, Joachim, Dr., 76684 Östringen (DE)
(74) Vertreter: Weber, Walter

(56) Entgegenhaltungen:
- EP-A2- 2 068 344
- US-A1- 2005 104 006
- US-A1- 2006 102 848

## Beschreibung

Die Erfindung betrifft einen Korrektor für die Farb- und Öffnungsfehlerkorrektur bei einem Raster-Elektronenmikroskop oder einem Raster-Transmissionselektronenmikroskop mit im Strahlengang nacheinander angeordneten vier Multipolelementen, von denen das erste und vierte zur Erzeugung von Quadrupolfeldern und das zweite und dritte zur Erzeugung von Oktupolfeldem und von Quadrupolfeldern dienen, wobei letztere übereinandergelagerte magnetische und elektrische Felder sind und wobei die Quadrupolfelder aller vier Multipolelemente von einem zum nächsten um 90° gedreht sind, so daß mittels astigmatischer Zwischenbilder in den zweiten und dritten Multipolelementen durch das Zusammenwirken der magnetischen und elektrischen Felder eine Farbfehlerkorrektur und mittels der Quadrupolfelder und der Oktupolfelder eine Öffnungsfehlerkorrektur möglich ist.

Der Zweck eines derartigen Korrektors besteht darin, daß der von der Strahlquelle kommende Strahl, bevor er nach dem Passieren einer Kondensorlinse in die Scannvorrichtung gelangt, derart veränderbar ist, daß die Farb- und Öffnungsfehler der Rundlinsen des Mikroskops gegenkompensierbar sind. Hierdurch wird der rasternde Punkt möglichst klein gemacht und exakt begrenzt. Dies ist Voraussetzung zur Erzeugung von kontrastreichen Rasterbildern hoher Auflösung.

Die Grundlage für die Funktion aller Korrektoren in der Teilchenoptik bildet die Erkenntnis von O. Scherzer (O. Scherzer: "Sphärische und chromatische Korrektur von Elektronen-Linsen" OPTIK, DE, JENA, 1947, Seiten 114-132, XP002090897, ISSN: 0863-0259), daß auch bei Teilchenstrahlen die Korrektur von Farb- und Öffnungsfehlern möglich ist, wenn man nicht-rotationssymmetrische Felder einsetzt, mit denen astigmatische Zwischenbilder erzeugt und dann dieser Astigmatismus wieder beseitigt wird. O. Scherzer stellt die Bedingungen auf, unter denen dies erreichbar ist (a.a.O.). Diese als Scherzer-Theorem bezeichneten Bedingungen sind Grundlage jeder Farb- und Öffnungsfehlerkorrektur in der Teilchenoptik.

Ausgehend von dieser Grundlage wurde von V. Beck und A.V. Crewe (V.Beck and A.,V. Crewe, "A Quadrupole-Octupole Corrector for a 100 keV STEM," Proceedings 32nd Annual EMSA Meeting, 1974, S. 426, 427) ein Korrektur zur Beseitigung des Öffnungsfehlers vorgeschlagen, der aus vier Quadrupolen mit einem mittig angeordneten Oktupol sowie einem vor- und einem nachgeordneten Oktupol besteht. Mit diesem Korrektor konnte jedoch kein Farbfehler beseitigt werden.

Um sowohl eine Öffnungs- als auch Farbfehlerkorrektur zu erzielen, wurde ausgehend von einem Vorschlag von H. Rose ("Abbildungseigenschaften sphärisch korrigierter elektronenmikroskopischer Achromate", Optik 33 (1971), S. 1-24) von J. Zach und M. Haider ein Korrektor der eingangs genannten Art entsprechend ihrer Veröffentlichung ("Aberration correction in al low voltage SEM by a multipole corrector", Nuclear Instruments and Methods in Physics Research A 363 (1995), 316-325) gebaut. Ein Problem derartiger Korrektoren besteht darin, daß sie selbst Fehler verursachen. Es handelt sich dabei um Fehler, wie Astigmatismus, Sternfehler, Rosettenfehler und Koma, die in verschiedenen Ordnungen auftreten. Wünschenswert ist es, diese Fehler möglichst weitgehend zu beseitigen. Desweiteren gelingt mit einem Korrektor der eingangs genannten Art nur eine Korrektur der Öffnungsfehler bis zur dritten Ordnung, der verbleibende Öffnungsfehler fünfter Ordnung ist jedoch immer noch störend.

Die WO 2007/065382 schlägt ein Korrektiv mit zwei zu einer Mittelebene antisymmetrischen Korrekturstücken vor. Jedes Korrektiv besteht aus fünf Multipolen mit fünf Quadrupolfeldern und mindestens einem - es können auch drei sein - Oktupolfeld. Nach einem Vorschlag kann das in der Symmetrieebene der Korrekturstücke liegende dritte Multipolelement ein Zwölfpolelement sein, das ein Oktupolfeld überlagert mit einem Zwölfpolfeld erzeugt. Zwischen den Korrektiven befindet sich ein Transferlinsensystem, das bewirkt, daß die Fundamentalbahn in das zweite Korrekturstück in gleicher Weise eintritt, wie in das erste Korrekturstück.

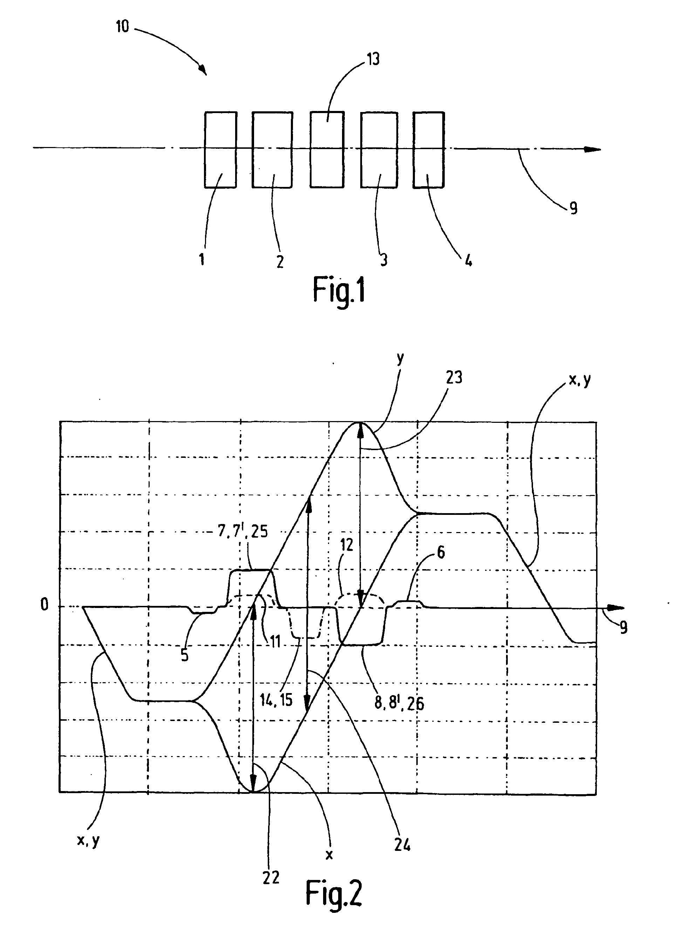

Diese Korrektiv arbeitet jedoch im Gegensatz zum eingangs genannten Korrektiv nicht nach dem Prinzip von Öffnungs- und Farbfehlerkorrekturen im Bereich astigmatischer Zwischenbilder, da solche gar nicht entstehen, sondern nach dem Prinzip einer Korrektur dieser Fehler in konjugierten anamorphen Ebenen der beiden Korrekturstücke. In den Symmetrieebenen der beiden Korrektive, in denen nach dem o.g. Vorschlag das Oktupolfeld mit einem überlagerten Zwölfpolfeld erzeugt wird, hat das von einem Bildpunkt ausgehende axiale Strahlenbündel nicht wie beim eingangs genannten Korrektor einen runden Strahlquerschnitt, sondern einen außerhalb der optischen Achse liegenden elliptischen Strahlquerschnitt. Dies führt neben der Korrektur eines vierzähligen Astigmatismuses 3. Ordnung jedoch zu weiteren verzerrenden Strahlbeeinflussungen, die jedoch deshalb unschädlich sind, weil das zweite Korrektiv durch die Antisymmetrie eine entgegengesetzte Strahlbeeinflussung erzeugt und somit die Verzerrungen kompensiert. Das Vorhandensein zweier Korrektive in antisymmetrischer Anordnung mit dem Transferlinsensystem ist somit unverzichtbar. Das zum Korrektor der eingangs genannten Art unterschiedliche Funktionsprinzip ohne astigmatische Zwischenbilder bedingt auch einen völlig anderen Strahlengang, der aus den Figuren 1, 2 und 3 ersichtlich ist.

Die US 7.015,481 B2 geht von der o.g. Veröffentlichung von J. Zach und M. Haider aus, welche auch die Verwendung von Zwölfpolen zur Erzeugung der eingangs genannten Felder beinhaltet. Dabei lehrt diese Schrift nicht die Hinzufügung weiterer Multipole, sondern eine Steuerung für die vorhandenen Multipole, um durch entsprechende Felder weitere Fehlerkorrekturen, insbesondere eines Öffnungsfehlers fünfter Ordnung vorzunehmen. Dabei spielt jedoch die vorgeschlagene Shew-Anordnung (Winkelversatz der Pole eines Multipolelements) für eine Korrekturmöglichkeit eher eine mittelbare Rolle. Sie dürfte eher zur Justage eingesetzt werden. Daß Fehler 5. Ordnung mittels eines Zwölfpolfeldes beeinflußbar sind, ist bekannt. Jedoch ergibt ein Zwölfpolfeld keine befriedigende Lösung, wenn das Zwölfpolfeld an den Stellen der vorgesehenen Multipole erzeugt wird, da die Beseitigung der Öffnungsfehler 5. Ordnung an diesen Stellen wiederum zum Entstehen anderer Fehler führt.

Der Erfindung liegt daher die Aufgabe zugrunde, einen Korrektor der eingangs genannten Art derart weiterzubilden, daß Fehler bis zur fünften Ordnung möglichst weitgehend beseitigt werden können.

Die Aufgabe wird erfindungsgemäß dadurch gelöst, daß zur Korrektur von Fehlern höherer Ordnung mittels Zwölfpolfeldern das zweite und das dritte Multipolelement als Zwölfpolelemente ausgebildet sind und ein zusätzliches Zwölfpolelement zwischen dem zweiten und dritten Multipolelement eingefügt und derart mit Strom und/oder Spannung beaufschlagt ist, daß ein Oktupolfeld überlagert mit einem Zwölfpolfeld entsteht, wobei die Anordnung des zusätzlichen Zwölfpolelements derart erfolgt, daß das Oktupolfeld und das Zwölfpolfeld an der Stelle zwischen den astigmatischen Zwischenbildern liegen, an der der Strahlquerschnitt rund ist..

Alle Felder des ersten und vierten Multipolelements, sowie die Oktupolfelder und Zwölfpolfelder des zweite und dritten Multipolelements und des zusätzlichen Zwölfpolelements können dabei magnetische oder elektrische Felder oder eine Kombination von beidem sein. In dieser Weise ist auch die Angabe zu verstehen, daß das zusätzliche Zwölfpolelement mit Strom und/oder Spannung beaufschlagt ist. Lediglich die Quadrupolfelder des zweiten und dritten Multipolelements müssen zusammenwirkende elektrische und magnetische Felder sein.

Der erfindungsgemäße Korrektor geht zunächst von den vorbekannten Funktionen aus, daß nach der Lehre von O. Scherzer (a.a.O.) das Quadrupolfeld des ersten Multipolelements dem Strahl eine Abweichung von der Rotationssymmetrie aufprägt, so daß in zwei aufeinander senkrechten Hauptschnitten, dem x- und dem y-Schnitt, die Strahlen unterschiedlich divergierend verlaufen. Das nachfolgende, um 90° gedrehte Quadrupolfeld des zweiten Multipolelements kann nur den Strahl eines Schnittes, beispielsweise des x-Schnitts, beeinflussen, der keinen Nulldurchgang hat, nicht dagegen den Teil des Strahls, der an dieser Stelle einen Nulldurchgang aufweist (y-Schnitt). Dieser Strahl (x-Schnitt) wird dabei derart umgelenkt, daß er parallel zum Strahl des anderen Schnitts, beispielsweise des y-Schnitts, verläuft. Dieselbe Umlenkung erfährt im wiederum um 90° gedrehten Quadrupolfeld des dritten Multipolelements der andere Strahlteil, so daß sich die Strahlen der senkrecht aufeinanderstehenden Hauptschnitte wieder aufeinanderzubewegen, um dann durch das Quadrupolfeld des vierten Multipolelements wieder zu einem runden Strahlenbündel vereinigt zu werden. Bei den vorgenannten Quadrupolfeldern kann es sich, wie erwähnt, um magnetische oder elektrische Felder oder eine Kombination aus beidem handeln. Die genannten Abweichungen von der Rotationssymmetrie dienen der Farb- und Öffnungsfehlerkorrektur nach dem Scherzer-Theorem (a.a.O.).

Die praktische Realisierung sieht zunächst vor, daß die Farbfehlerkorrektur bezüglich eines Schnittes, beispielsweise des x-Schnittes, mit dem zweiten Multipolelement und des anderen Schnittes, beispielsweise des y-Schnittes, mit dem dritten Multipolelement erfolgt. Die Funktion der Farbfehlerkorrektur entspricht dem bekannten Wienfilter und beruht darauf, daß die Quadrupolfelder aus sich überlagernden elektrischen und magnetischen Quadrupolfeldern bestehen. Die Feldstärken sind dabei so ausgelegt, daß Elektronen einer bestimmten Geschwindigkeit - also einer bestimmten Energie und in Relation zur Lichtoptik einer bestimmten Farbe - die Felder auf ihrem vorbestimmten Weg passieren. Die Elektronen abweichender Energien verlassen den vorbestimmten Weg und können damit den Farbfehler der Rundlinsen des Mikroskops, insbesondere der Objektivlinse, gegenkompensieren. Nur für diese Farbfehlerkorrektur ist daher die Kombination aus elektrischem und magnetischem Feld erforderlich.

Bezüglich der Öffnungsfehler erfolgt die Korrektur ebenfalls im zweiten und dritten Multipolelement mittels deren Oktupolfelder. Die Öffnungsfehler kommen von den rotationssymmetrischen Linsen des Elektronenmikroskops, da diese in größerer Entfernung von der optischen Achse verlaufende Strahlen stärker beeinflussen. Dies führt dazu, daß die Strahlen im Bereich von Zwischenbildern keinen gemeinsamen Schnittpunkt mit der optischen Achse bilden. Im Bereich der astigmatischen Zwischenbilder lassen sich die Strahlen des jeweiligen Schnittes, der keinen Nulldurchgang hat, durch die Oktupolfelder derart beeinflussen, daß sich die Strahlen wieder in der Bildebene schneiden. Wird die Korrektur für die Strahlen eines jeden Schnittes nacheinander durchgeführt und diese Strahlen dann wieder zu einem runden Strahl zusammengeführt, ist die Öffnungsfehlerkorrektur erfolgt. Dabei ist es jedoch nicht nur möglich, Öffnungsfehler vorgeordneter Rundlinsen zu korrigieren, es können auch Fehler nachgeordneter Rundlinsen vorkompensiert werden. Dann wird dem Strahlengang ein derartiger Öffnungsfehler aufgeprägt, daß er sich mit den Öffnungsfehlern der nachgeordneten Rundlinsen, beispielsweise des Objektivs, wieder aufhebt.

Mit diesen vorbekannten Korrekturen tritt jedoch das Problem auf, daß der Korrektor seinerseits wiederum Fehler verursacht. Dabei handelt es sich vor allem um umrunde Fehler, insbesondere um einen vierzähligen Astigmatismus dritter Ordnung und einen Sternfehler fünfter Ordnung. Die unrunden Fehler bilden axiale Bildfehlerfiguren und werden nach diesen Figuren in eingangs erwähnter Weise eingeteilt. Was weiterhin als runder Fehler verbleibt, ist ein Öffnungsfehler fünfter Ordnung.

An dieser Stelle setzen die erfindungsgemäßen Maßnahmen zur Beseitigung der vorgenannten Fehler ein. Der Versuch, diese Fehler dadurch zu beseitigen, daß das zweite und dritte Mehrpolelement als Zwölfpole ausgebildet wurden, erbrachte zwar bei entsprechender Feldeinstellung eine Beseitigung des Sternfehlers fünfter Ordnung und eine starke Reduzierung des Öffnungsfehlers fünfter Ordnung, jedoch keine Korrektur des vierzähligen Astigmatismuses dritter Ordnung.

Erst die Einfügung eines zusätzlichen Zwölfpolelementes zwischen dem zweiten und dritten Multipolelement mit einer derartigen Strom- und/oder Spannungsbeaufschlagung, daß ein Oktupolfeld überlagert mit einem Zwölfpolfeld entsteht, gestattete es, durch entsprechende Einstellung der Felder alle Fehler bis zur fünften Ordnung bis auf kleine Restfehler zu korrigieren, ohne durch diese Maßnahmen wiederum erneut Fehler zu verursachen.

Dabei hat sich gezeigt, daß die optimale Anordnung des zusätzlichen Zwölfpolelements an der Stelle zwischen den astigmatischen Zwischenbildern erfolgt, an der der Strahlenquerschnitt rund ist. Das ist die Stelle, an der der Strahl des x-Schnitts und der Strahl des y-Schnitts gleich weit von der optischen Achse entfernt sind.

Weiterbildungen der Erfindung sehen vor, auch die noch vorhandenen Restfehler so weit wie möglich zu beseitigen. Diese kleinen Restfehler werden durch die sich außerhalb des Korrektors befindlichen Rundlinsen verursacht. Dabei handelt es sich insbesondere um einen zwar verminderten, aber doch noch störenden Öffnungsfehler fünfter Ordnung.

Dazu wird vorgeschlagen, dem Korrektor objektivseitig zwei als Rundlinsen ausgebildete Transferlinsen zuzuordnen, deren Felder so einstellbar sind, daß die runden Fehler höherer Ordnung verschwinden. Diese Maßnahme führt jedoch wiederum zu Fehlern, insbesondere wird die Korrektur des Öffnungsfehlers dritter Ordnung sowie die Farbfehlerkorrektur teilweise wieder rückgängig gemacht. Deshalb ist ein Nachjustieren der zweiten und dritten Multipolelemente zweckmäßig, wobei sowohl die Quadrupolfelder als auch die Oktupolfelder nachzujustieren sind. Bei der Nachjustierung der Quadrupolfelder müssen die magnetischen und elektrischen Felder insoweit simultan verstellt werden, daß die Farbfehlerkorrektur - wie oben beschrieben - erhalten bleibt. Ein Abweichen von dieser Simultanverstellung ist jedoch insoweit erforderlich, als ein durch die Einstellung der Transferlinsen wiederauftretender Farbfehler nachkorrigiert werden muß.

Da die Einfügung der Transferlinsen sowie jede Verstellung, wie die vorgenannte Nachjustierung den Strahlengang wieder verändert, ist es zweckmäßig, wiederauftretende Fehler höherer Ordnung durch eine Nachjustierung der Zwölfpolfelder der zweiten und dritten Multipole und des zusätzlichen Zwölfpolelements zu beseitigen.

Da durch die Nachjustierung der zweiten und dritten Multipolelemente sowie des zusätzlichen Zwölfpolelements wieder runde Fehler höherer Ordnung entstehen, sind die Transferlinsen wieder nachzujustieren, und danach müssen wieder die Multipolelemente und das Zwölfpolelement in vorbeschriebener Weise nachjustiert werden. Da jede Verstellung der vorgenannten Elemente in angegebener Weise wieder Fehler zum Entstehen bringt, muß in iterativer Wiese eine Wiederholung der vorgenannten Einzelschritte erfolgen, bis alle Fehler auf ein für die gewünschte Bildgebung tolerierbares Maß reduziert sind.

Ein Korrektor der erfindungsgemäßen Art läßt sich prinzipiell in jedes Elektronenmikroskop einfügen, das nach dem Rasterprinzip arbeitet. Der erfindungsgemäße Korrektor weist dabei die baulichen Voraussetzungen, wie den räumlichen Aufbau, die Wicklungen und Materialeigenschaften sowie die erforderlichen Einstellbereiche für Strom und/oder Spannung zur Erzeugung und Regulierung der Feldstärken der jeweiligen magnetischen und/oder elektrischen Felder auf, um die beschriebenen Einstellungen und Justierungen beziehungsweise Nachjustierungen vornehmen zu können.

Die Charakterisierung von Feldern des Korrektors dahingehend, daß Einstellungen und Justierungen beziehungsweise Nachjustierungen möglich sind, bedeutet daher folgendes: Die baulichen Ausgestaltungen von Elektroden und/oder Elektromagneten und deren Beaufschlagungsmöglichkeit mit Strom beziehungsweise Spannung muß derart sein, daß nach dem Einbau des Korrektors in ein Elektronenmikroskop die angegebenen Korrekturmaßnahmen möglich sind. Durchgeführt werden diese Einstellungen, Justierungen und Nachjustierungen nach dem Einbau und der Inbetriebnahme des jeweiligen Elektronenmikroskops, da die konkreten Einstellungen sowohl von dessen Bauart als auch von den individuellen Linsenfehlern abhängt, welche auch bei Elektronenmikroskopen der gleichen Baureihen individuell auftreten, beispielsweise durch Maßungenauigkeiten und Materialinhomogenitäten. Auch muß beim Betrieb eines Elektronenmikroskops von Zeit zu Zeit eine Nachjustierung erfolgen, da schon geringste Verschmutzungen die optischen Eigenschaften verändern und eine solche erforderlich machen können. Realisiert ist die Erfindung in einem Korrektor, der diese Korrekturmöglichkeiten des Elektronenstrahls ermöglicht. Die Konkretisierung der baulichen Ausgestaltung des Korrektors sowie die konkret zur Verfügung gestellten Strom und/oder Spannungsbereiche, die für die Einstellungen und Korrekturen erforderlich sind, richten sich nach der Bauart des jeweiligen Elektronenmikroskops, insbesondere nach den jeweiligen Strahlspannungen der möglichen Arbeitsbereiche und der konkreten Ausgestaltung von Linsensystem und Rastereinrichtung.

Da die angegebenen Eigenschaften des erfindungsgemäßen Korrektors ihre Wirkung nach dem Einbau in ein Elektronenmikroskop entfalten, betrifft die Erfindung auch ein Raster-Elektronenmikroskop oder Raster-Transmissionselektronenmikroskop mit einem Korrektor der vorgenannten Art, bei dem eine Korrektur des Elektronenstrahls in vorbeschriebener Weise vorgenommen wurde.

Die Erfindung wird nachfolgend anhand der Zeichnung erläutert. Es zeigen
- **Fig. 1**: eine schematische Darstellung des erfindungsgemäßen Korrektors
- **Fig. 2**: entsprechend zu Fig. 1 den Strahlenverlauf in den Ebenen x und y sowie die Anordnung der Felder,
- **Fig. 3**: eine schematische Teilansicht eines Elektronenmikroskops mit einem Korrektor und
- **Fig. 4**: eine schematische Darstellung eines Zwölfpolelements, das ein Oktupolfeld erzeugt.

**Fig. 1** zeigt eine schematische Darstellung des erfindungsgemäßen Korrektors 10. In Richtung des Strahlengangs 9 sind ein erstes 1 und ein zweites Multipolelement 2 angeordnet, dann folgt ein Zwölfpolelement 13 und danach ein drittes 3 und ein viertes Multipolelement 4.
**Fig. 2** zeigt den Strahlenverlauf des Korrektors 10 in zwei senkrecht aufeinander stehenden Ebenen, also im x-Schnitt und im y-Schnitt mit den Strahlengängen der Kurven x und y. Des weiteren zeigt Fig. 2 die Felder, welche durch die Multipolelemente 1, 2, 3 und 4 sowie das Zwölfpolelement 13 erzeugt werden. Der Strahlengang geht in Richtung des Pfeils 9 und die optische Achse 27 verläuft durch die "0" der senkrechten Skala.

Wie aus der Zusammenschau der Fig. 1 und 2 ersichtlich ist, sind das erste 1 und das vierte Multipolelement 4 zur Erzeugung von Quadrupolfeldern 5 und 6 ausgebildet. Es kann sich dabei um elektrische oder magnetische Quadrupolfelder 5, 6 oder eine Kombination von beidem handeln. Die Multipolelemente 1 und 4 müssen dazu mindestens vier Elektromagnete und/oder vier Elektroden in axialsymmetrischer Anordnung aufweisen.

Das zweite 2 und dritte Multipolelement 3 sind als Zwölfpolelemente ausgebildet, wobei sie elektrische 7' und 8' und magnetische Quadrupolfelder 7, 8 erzeugen können, indem beispielsweise die Weicheisenkerne der Elektromagneten gleichzeitig als Elektroden dienen. Das zweite 2 und dritte Multipolelement 3 wird dabei derart mit Strom für die Elektromagneten bzw. mit einem Potential für die Elektroden beaufschlagt, daß diese magnetische Quadrupolfelder 7, 8 sowie elektrische Quadrupolfelder 7' und 8' erzeugen, die derart zusammenwirken, daß die eingangs beschriebene Farbfehlerkorrektur erfolgen kann.

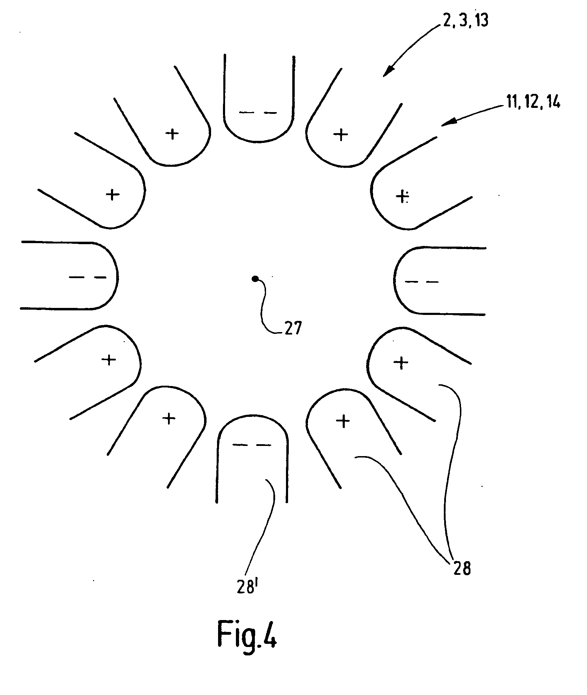

Weiterhin erzeugen das zweite 2 und dritte Multipolelement 3 Zwölfpolfelder 25 und 26 sowie Oktupolfelder 11 und 12, welche ebenfalls elektrische oder magnetische Felder oder eine Kombination von beiden sein können. (Wie mit einem Zwölfpolelement ein Oktupolfeld erzeugbar ist, wird noch zu Fig. 4 erläutert). Weiterhin ist aus Fig. 2 noch das Zwölfpolfeld 15 des Zwölfpolelements 13 sowie das durch dieses erzeugte Oktupolfeld 14 ersichtlich.

Wesentlich für die Korrektur von Farbfehlern und Öffnungsfehlern ist zunächst die Bildung eines unrunden Strahlengangs, mit astigmatischen Zwischenbilder, entsprechend der Doppelpfeile 22 und 23, da dort die Korrekturen nach der Lehre von Scherzer (siehe oben) vornehmbar sind. Beim astigmatischen Zwischenbild 22 entsteht ein Strichfokus in x-Richtung, da die Strahlen des y-Schnittes einen Nulldurchgang aufweisen, aber nicht die Strahlen des x-Schnittes. Beim astigmatischen Zwischenbild 23 entsteht in entsprechender Weise ein Strichfokus in y-Richtung. Danach werden die Strahlengänge wieder zu einem runden Strahlenbündel x, y vereint.

Um diesen Strahlengang zu erzeugen, werden die vier Quadrupolfelder 5, 7, 8 und 6 der Multipolelemente 1, 2, 3 und 4 eingesetzt, welche wie kombinierte Zylinder- und Rundlinsen in der Lichtoptik wirken. Dabei führt das Quadrupolfeld 5 des ersten Multipolelements 1 die Strahlen der Schnitte x und y auseinander und das Quadrupolfeld 7 des zweiten Multipolelements 2 lenkt am Nulldurchgang von y den x-Strahl um. Spiegelbildlich dazu lenkt das Quadrupolfeld 8 des dritten Multipolelements 3 am Nulldurchgang von x den y-Strahl um, und das Quadrupolfeld 6 des vierten Multipolelements 4 vereint die Strahlen der Schnitte x und y wieder zu einem runden Strahl x, y. Zu diesem Zweck sind die Quadrupolfelder 5, 7, 8 und 6 in Richtung des Strahlengangs 9 jeweils um 90° gedreht. Die Schnitte x und y dienen natürlich nur der Darstellung der Strahlverformung, welche man sich räumlich vorstellen muß. Bei derartigen unrunden Feldern, verhält es sich wie bei den Zylinderlinsen der Lichtoptik, wo es ebenfalls möglich ist, durch die Anordnung entgegenwirkender Zylinderlinsen die herbeigeführte Verzeichnung des Strahlengangs wieder zu eliminieren. Das ganze dient dazu, Farbfehler und Öffnungsfehler eines Elektronenstrahls zu korrigieren, was nach dem Scherzer-Theorem nur im Bereich der astigmatischen Zwischenbilder möglich ist.

Die Öffnungsfehlerkorrektur erfolgt durch die Oktupolfelder 11, 12 und die Fehler höherer Ordnung, einschließlich einer weitgehenden Reduzierung des Öffnungsfehlers fünfter Ordnung werden durch die Zwölfpolfelder 25 und 26 des zweiten 2 und dritten Multipolelements 3 korrigiert. Ein verbleibender vierzähliger Astigmatismus dritter Ordnung sowie der Rest des Öffnungsfehlers fünfter Ordnung werden dann noch erfindungsgemäß durch das Zwölfpolfeld 15 und das Oktupolfeld 14 des zusätzlichen Zwölfpolelements 13 korrigiert. Diese werden in der Spiegelsymmetrieebene angeordnet, da dort, wie der Pfeil 24 zeigt, durch den gleichen Betrag von x und y ein runder Strahlquerschnitt vorhanden ist.

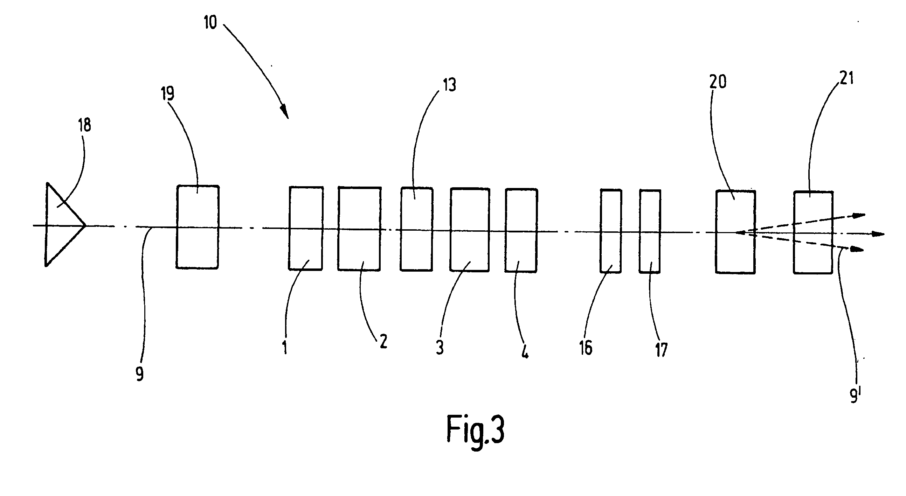

**Fig. 3** zeigt eine schematische Teilansicht eines Elektronenmikroskops, das ein Raster-Elektronenmikroskop oder ein Raster-Transmissionselektronenmikroskop sein kann. Der erfindungsgemäße Korrektor 10 wird im Strahlengang 9 nach der Strahlenquelle 18 und der Kondensorlinse 19 eingefügt. Nach dem Korrektor 10 folgen die Transferlinsen 16 und 17 mit deren Rundlinsenfelder und der oben beschriebenen iterativen Einstellung, mit welcher die Korrekturqualität des Korrektors 10 weiter verbessert werden kann.

Nach den Transferlinsen 16 und 17 folgt das Ablenksystem 20 zur Erzeugung des abgelenkten Strahls 9', also des Rasterstrahls, welcher mittels des Objektivs 21 auf das nicht dargestellte Objekt gerichtet wird. Durch Abscannen mit dem Rasterstrahl wird ein Bild von dem Objekt erzeugt. Dabei erfolgt die Bilderzeugung beim Raster-Transmissionselektronenmikroskop (übliche Bezeichnung: "STEM"- scanning transmission electron microscope) dadurch, daß der Rasterstrahl eine Dünnschnittprobe durchstrahlt. Beim Rasterelektronenmikroskop (übliche Bezeichnung: "SEM"- scanning electron microscope) werden durch den Rasterstrahl vom Objekt Sekundärelektronen zurückgestrahlt. Diese werden mittels eines Detektors erfaßt und zur Bilderzeugung genutzt. Heute werden oft Elektronenmikroskope, die nach dem Rasterprinzip arbeiten, derart gebaut, daß sie als Raster-Transmissionselektronenmikroskop oder als Raster-Elektronenmikroskop nach dem Reflektionsprinzip arbeiten können. Der erfindungsgemäße Korrektor 10 ist für beide Arbeitsweisen geeignet.

**Fig. 4** zeigt eine schematische Darstellung eines Zwölfpolelements, wobei es sich um das zweite 2 oder dritte Multipolelement 3 oder das zusätzliche Zwölfpolelement 13 handeln kann. Die Zwölfpole 28, 28' sind achssymmetrisch um die optische Achse 27 angeordnet. Wird damit ein Zwölfpolfeld erzeugt, so sind die Pole der Reihe nach immer abwechselnd als Nord- und Südpole zur Erzeugung von magnetischen Feldern oder als negativ und positiv geladene Elektroden zur Erzeugung von elektrischen Feldern ausgebildet.

Soll eine Kombination eines elektrischen und eines magnetischen Feldes erzeugt werden, so dienen die Weicheisenkerne der Elektromagneten gleichzeitig als Elektroden, die mit einer Spannung beaufschlagt sind.

Soll ein Quadrupolfeld erzeugt werden, so sind immer drei Elektromagneten oder Elektroden 28, 28' mit gleicher Polarität oder Ladung zusammengefaßt und die Dreiergruppen wechseln als Nord- und Südpole oder als negativ beziehungsweise positiv geladene Elektroden ab. Auch dabei können elektrische und magnetische Felder überlagert sein. Eine solche Überlagerung kann einer Verstärkung dienen oder einem derartigen Zusammenwirken, daß in der Art eines Wienfilters in oben beschriebener Weise durch magnetische 7, 8 und elektrische Felder 7', 8' eine Farbfehlerkorrektur erzielt ist.

Sollen dagegen Oktupolfelder 11, 12 oder 14 erzeugt werden, so müssen sich die Pole wie durch die "+" und "-" Zeichen dargestellt, abwechseln. Es folgen also zwei positiv geladene Elektroden 28 und eine negativ geladene Elektrode 28' in abwechselnder Reihe, wobei die negative Ladung (wie durch die zwei "-" Zeichen symbolisiert) entsprechend verstärkt sein muß; um ein möglichst unverzerrtes Oktupolfeld 11, 12, oder 14 zu erzielen. Bei der Erzeugung eines magnetischen Oktupols verhält sich dies dann entsprechend.

Überlagerte Felder, wie Quadrupolfeld, Oktupolfeld und Zwölfpolfeld, erzeugt durch ein einziges Zwölfpolelement erhält man dadurch, daß in den jeweiligen Polen - also in den Elektromagneten oder Elektroden - die Ströme bzw. Spannungen aufsummiert werden. Auf diese Weise lassen sich alle oben erwähnten Feldüberlagerungen herstellen.

### Korrektor

### Bezugszeichenliste

- 1,2,3 4: erstes, zweites, drittes und viertes Multipolelement
- 5,6: Quadrupolfelder des ersten und vierten Multipolelements
- 7,8: magnetische Quadrupolfelder des zweiten und dritten Multipolelements
- 7',8': elektrische Quadrupolfelder des zweiten und dritten Multipolelements
- 9: Pfeil: Strahlengang
- 9': Pfeil: Strahlengang abgelenkt (Rasterstrahl)
- 10: Korrektor
- 11,12: Oktupolfelder des zweiten und dritten Multipolelements
- 13: zusätzliches Zwölfpolelement
- 14: Oktupolfeld des Zwölfpolelements
- 15: Zwölfpolfeld des Zwölfpolelements
- 16,17: Transferlinsen
- 18: Strahlquelle
- 19: Kondensorlinse
- 20: Ablenksystem
- 21: Objektiv
- 22: Doppelpfeil: Erstes astigmatisches Zwischenbild
- 23: Doppelpfeil: Zweites astigmatisches Zwischenbild
- 24: Pfeil: runder Strahlquerschnitt
- 25: Zwölfpolfeld des zweiten Multipolelements
- 26: Zwölfpolfeld des dritten Multipolelements
- 27: optische Achse
- 28: Elektromagnet und/oder Elektrode (Südpol oder positiv geladene Elektrode)
- 28': Elektromagnet und/oder Elektrode (Nordpol oder negativ geladene Elektrode)

## Patentansprüche

1. Korrektor (10) für die Farb- und Öffnungsfehlerkorrektur bei einem Raster-Elektronenmikroskop oder einem Raster-Transmissionselektronenmikroskop mit im Strahlengang (9) nacheinander angeordneten vier Multipolelementen (1, 2, 3, 4), von denen das erste (1) und vierte (4) zur Erzeugung von Quadrupolfeldern (5, 6) und das zweite (2) und dritte (3) zur Erzeugung von Oktupolfeldem (11, 12) und von Quadrupolfeldern (7, 7', 8, 8') dienen, wobei letztere übereinandergelagerte magnetische (7, 8) und elektrische Felder (7', 8') sind und wobei die Quadrupolfelder (5, 6, 7, 8) aller vier Multipolelemente (1, 2, 3, 4) von einem zum nächsten um 90° gedreht sind, so daß mittels astigmatischer Zwischenbilder (22, 23) in den zweiten und dritten Multipolelementen (2, 3) durch das Zusammenwirken der magnetischen (7, 8) und elektrischen Felder (7', 8') eine Farbfehlerkorrektur und mittels der Quadrupolfelder (5, 6, 7, 8) und der Oktupolfelder (11, 12) eine Öffnungsfehlerkorrektur möglich ist,
**dadurch gekennzeichnet,**
**daß** zur Korrektur von Fehlern höherer Ordnung mittels Zwölfpolfeldern (25, 26) das zweite (2) und das dritte Multipolelement (3) als Zwölfpolelemente ausgebildet sind und ein zusätzliches Zwölfpolelement (13) zwischen dem zweiten (2) und dritten Multipolelement (3) eingefügt und derart mit Strom und/oder Spannung beaufschlagt ist, daß ein Oktupolfeld (14) überlagert mit einem Zwölfpolfeld (15) entsteht, wobei die Anordnung des zusätzlichen Zwölfpolelements (13) derart erfolgt, daß das Oktupolfeld (14) und das Zwölfpolfeld (15) an der Stelle zwischen den astigmatischen Zwischenbildern (22, 23) liegen, an der der Strahlquerschnitt rund (24) ist.

2. Korrektor nach Anspruch 1,
derart ausgestalkt
daß dem Korrektor (10) objektivseitig zwei als Rundlinsen ausgebildete Transferlinsen (16, 17) zugeordnet werden, deren Felder so einstellbar sind, daß die runden Fehler höherer Ordnung verschwinden.

3. Korrektor nach Anspruch 2,
derart ausgestalkt
daß eine Nachjustierung der Quadrupol- (7, 7', 8, 8') und Oktupolfelder (11, 12, 14) des zweiten (2) und dritten Multipolelements (3) und des Oktupolfeldes (14) des zusätzlichen Zwölfpolelements (13) möglich ist, derart, daß der durch die vorgenannte Einstellung der Transferlinsen (16, 17) erneut verursachte Farbfehler erster und Öffnungsfehler dritter Ordnung wieder beseitigt ist.

4. Korrektor nach Anspruch 3,
derart ausgestalkt
daß eine Nachjustierung der Zwölfpolfelder (13, 25, 26) des zweiten (2) und dritten Multipols (3) und des zusätzlichen Zwölfpolelements (13) möglich ist, um die durch die Transferlinsen (16, 17) und die vorgenannte Nachjustierung wiederaufgetretenen Fehler höherer Ordnungen wieder zu beseitigen.

5. Korrektor nach Anspruch 3 und 4,
derart ausgestalkt
daß eine Beseitigung der Farbfehler erster und Öffnungsfehler dritter sowie Fehler höherer Ordnung durch eine Nachjustierung von Transferlinsen (16, 17), Quadrupolfeldern (7, 7', 8, 8') und Oktupolfeldern (11, 12, 14) und danach von Zwölfpolfeldern (15, 25, 26) sowie eine iterative Einstellung in den vorgenannten Schritten zur Verminderung der durch die jeweils vorangegangenen Nachjustierungen wiederum verursachten Fehler möglich sind, bis diese auf eine für die gewünschte Bildgebung tolerierbare Größe reduziert sind.

6. Raster-Elektronenmikroskop oder Raster-Transmissionselektronenmikroskop, mit einem
Korrektor (10) nach einem der Ansprüche 1 bis 5.

## Claims

1. Corrector (10) for chromatic and aperture aberration correction in a scanning electron microscope or a scanning transmission electron microscope, comprising four multipole elements (1, 2, 3, 4) which are consecutively disposed in the optical path (9), the first (1) and fourth (4) of which are used to generate quadrupole fields (5, 6) and the second (2) and third (3) of which are used to generate octupole fields (11, 12) and quadrupole fields (7, 7', 8, 8'), wherein the latter are superposed magnetic (7, 8) and electric fields (7', 8') and wherein the quadrupole fields (5, 6, 7, 8) of all four multipole elements (1, 2, 3, 4) are consecutively rotated with respect to one another through 90°, such that chromatic aberration correction can be performed through interaction between the magnetic (7, 8) and electric (7', 8') fields using astigmatic intermediate images (22,23) in the second and third multipole elements (2, 3), and aperture aberration correction can be performed through quadruple fields (5, 6, 7, 8) and octupole fields (11, 12), **characterized in that** the second (2) and the third multipole elements (3) are designed as twelve-pole elements for correcting aberrations of higher order using twelve-pole fields (25, 26), and an additional twelve-pole element (13) is inserted between the second (2) and the third (3) multipole element and is loaded with current and/or voltage such that an octupole field (14) is generated that is superposed by a twelve-pole field (15), wherein the additional twelve-pole element (13) is arranged in such a fashion that the octupole field (14) and the twelve-pole field (15) are located between the astigmatic intermediate images (22, 23) where the beam cross section is round (24).

2. Corrector according to claim 1, developed in such a way that two transfer lenses (16, 17) are associated with the corrector (10) on the objective side, which are formed as round lenses and whose fields can be adjusted in such a fashion that the round aberrations of higher order are eliminated.

3. Corrector according to claim 2, developed in such a way that readjustment of the quadrupole (7, 7', 8, 8') and octupole fields (11, 12, 14) of the second (2) and third (3) multipole elements and of the octupole field (14) of the additional twelve-pole element (13) can be performed in such a fashion that the chromatic aberration that was caused again by the previously mentioned adjustment of the transfer lenses (16, 17) of first order, and the aperture aberration of third order are eliminated again.

4. Corrector according to claim 3, developed in such a way that the twelve-pole fields (13, 25, 26) of the second (2) and third (3) multipoles and of the additional twelve-pole element (13) can be readjusted in order to eliminate again the aberrations of higher orders caused again by the readjustment of the transfer lenses (16, 17) and the above-mentioned readjustment.

5. Corrector according to claims 3 and 4, developed in such a way that chromatic errors of first order, aperture errors of third order, and aberrations of higher order can be eliminated through readjustment of transfer lenses (16, 17), quadrupole fields (7, 7', 8, 8'), octupole fields (11, 12, 14), and subsequently of twelve-pole fields (15, 25, 26), as well as through iterative adjustment in the above-mentioned steps for reducing the aberrations caused, in turn, by the respective previous readjustments, until they are reduced to an amount that can be tolerated for the desired imaging.

6. Scanning electron microscope or scanning transmission electron microscope with a corrector (10) according to any one of the claims 1 through 5.

## Revendications

1. Correcteur (10) pour la correction d'aberration chromatique et d'erreur d'ouverture dans le cas d'un microscope électronique à balayage ou d'un microscope électronique à transmission à balayage avec quatre éléments multipolaires (1, 2, 3, 4) disposés successivement dans la trajectoire du faisceau (9), dont le premier (1) et le quatrième (4) servent à générer des champs quadripolaires (5, 6) et le second (2) et le troisième (3) à générer des champs octupolaires (11, 12) et des champs quadripolaires (7, 7', 8, 8'), ces derniers étant des champs magnétiques (7, 8) et des champs électriques (7', 8') superposés et les champs quadripolaires (5, 6, 7, 8) de l'ensemble des quatre éléments multipolaires (1, 2, 3, 4) étant tourné de 90° d'un champ à l'autre, de sorte qu'une correction d'aberration chromatique est possible au moyen d'images intermédiaires (22, 23) astigmatiques dans les seconds et troisièmes éléments multipolaires (2, 3) par l'action conjuguée des champs magnétiques (7, 8) et des champs électriques (7', 8') et une correction d'erreur d'ouverture est possible au moyen des champs quadripolaires (5, 6, 7, 8) et des champs octupolaires (11, 12),
**caractérisé en ce que,**
pour la correction de défauts d'ordre supérieur au moyen de champs à douze pôles (25, 26), le second (2) et le troisième éléments multipolaires (3) sont conçus comme des éléments à douze pôles et un élément à douze pôles (13) supplémentaire est inséré entre le second (2) et le troisième éléments multipolaires (3) et est alimenté avec du courant et/ou de la tension de telle sorte qu'un champ octupolaire (14) se forme de façon superposée avec un champ à douze pôles (15), l'agencement de l'élément à douze pôle (13) supplémentaire s'effectuant de telle sorte que le champ octupolaire (14) et le champ à douze pôles (15) se situent à l'emplacement entre les images intermédiaires (22, 23) astigmatiques, où la section de faisceau est ronde (24).

2. Correcteur selon la revendication 1,
conçu de telle sorte que
deux lentilles de transfert (16, 17) conçues comme des lentilles rondes sont attribuées au correcteur (10), lentilles dont les champs peuvent être réglés de telle sorte que les champs ronds d'ordre supérieur disparaissent.

3. Correcteur selon la revendication 2,
conçu de telle sorte
qu'un ajustage complémentaire des champs quadripolaires (7, 7', 8, 8') et des champs octupolaires (11, 12, 14) du second (2) et du troisième éléments multipolaires (3) et du champ octupolaire (14) de l'élément à douze pôles (13) supplémentaire est possible de telle sorte que l'aberration chromatique de premier ordre et l'erreur d'ouverture de troisième ordre, provoquées à nouveau par le réglage susmentionné des lentilles de transfert (16, 17), sont à nouveau éliminées.

4. Correcteur selon la revendication 3,
conçu de telle sorte
qu'un réajustage des champs à douze pôles (13, 25, 26) du second (2) et du troisième multipôles (3) et de l'élément à douze pôles (13) supplémentaire est possible, afin d'éliminer à nouveau les défauts d'ordres supérieurs qui apparaissent en raison des lentilles de transfert (16, 17) et du réajustage susmentionné.

5. Correcteur selon les revendications 3 et 4,
conçu de telle sorte
qu'une élimination des observations chromatiques de premier ordre et des défauts d'ouverture de troisième ordre ainsi que des erreurs d'ordre supérieur par un réajustage de lentilles de transfert (16, 17), de champs quadripolaires (7, 7', 8, 8') et de champs octupolaires (11, 12, 14) et ensuite de champs à douze pôles (15, 25, 26) et par un réglage itératif dans les étapes susmentionnées sont possibles pour réduire les défauts causés à nouveau par les réajustages respectivement antérieurs jusqu'à ce que ces défauts soient réduits à une grandeur tolérable pour la conception d'image souhaitée.

6. Microscope électronique à balayage ou microscope électronique à transmission à balayage doté d'un correcteur (10) selon l'une quelconque des revendications 1 à 5.
